# EUROPEAN PATENT SPECIFICATION

(11) **EP 1 776 488 B1**
(45) Date of publication and mention of the grant of the patent: **13.04.2016**
(21) Application number: 04740558.4
(22) Date of filing: 30.06.2004
(51) Int. Cl.: C23C 14/22, C23C 14/56, C23C 14/02, C23C 28/02, B21F 19/00, C23C 14/54

(54) **METHOD FOR PRODUCING A METAL WIRE COATED WITH A LAYER OF BRASS.**
VERFAHREN ZUR HERSTELLUNG EINES MIT EINER MESSINGSCHICHT ÜBERZOGENEN METALLDRAHTS
PROCEDÉ DE FABRICATION D'UN FIL METALLIQUE ENROBÉ D'UNE COUCHE DE LAITON

(43) Date of publication of application: 25.04.2007
(73) Proprietor: NV Bekaert SA, 8550 Zwevegem (BE)
(72) Inventor: PAVAN, Federico, c/o Pirelli Pneumatici S.p.A., I-20126 Milano (IT); AGRESTI, Simone, c/o Pirelli Pneumatici S.p.A., I-20126 Milano (IT)
(74) Representative: Seynhaeve, Geert Filiep
(86) International application number: PCT/EP2004/007197
(87) International publication number: WO 2006/002673

(56) References cited:
- EP-A- 0 241 721
- EP-A- 1 231 292
- GB-A- 1 300 487
- US-B1- 6 303 008
- PATENT ABSTRACTS OF JAPAN vol. 007, no. 151 (C-174), 1 July 1983 (1983-07-01) & JP 58 061297 A (SUMITOMO DENKI KOGYO KK), 12 April 1983 (1983-04-12)
- PATENT ABSTRACTS OF JAPAN vol. 007, no. 147 (C-173), 28 June 1983 (1983-06-28) & JP 58 058297 A (SUMITOMO DENKI KOGYO KK), 6 April 1983 (1983-04-06)

## Description

### Field of the invention

The present invention refers to a method for producing a coated metal wire for reinforcing elastomeric materials, such as for example semi-finished products which can be used for the manufacture of tires, tubes, conveyor belts, transmission belts or cables.

In particular, the present invention refers to a method for producing a coated metal wire comprising a metal core and a coating layer made of a metal alloy material, such as for example brass, as well as to a coated metal wire of such type.

The present invention further relates to a method for producing a metal cord comprising a plurality of the above-mentioned coated metal wires as well as to such a metal cord.

### Prior art

Generally, tire manufacturing methods make use of coated metal wires or cords (the latter comprising a plurality of wires stranded together) which are embedded in an elastomeric material to form, for example, a belt layer or a carcass layer of a tire.

In such a metal wire a metal core is typically provided with a metal coating layer to carry out the dual function of providing a suitable corrosion resistance to the wire and of ensuring a good adhesion thereof to the vulcanized elastomeric material.

For example, documents EP-A-0 669 409, EP-A-0 694 631 and EP-A-0 949 356 - all in the name of the Applicant - disclose methods for producing a coated metal wire comprising the step of electrochemically depositing a metal coating layer onto a metal core, said metal coating layer consisting of an alloy of at least two metal components.

In case a brass coating layer is provided onto a steel core by means of electrochemical deposition, the method essentially involves the following steps:
- an electrodeposition step in two distinct electrolytic baths, in which a copper plating and a zinc plating of the steel core are successively carried out;
- a thermal treatment step to allow zinc diffusion into copper to form the brass alloy;
- a pickling step in acid solution, typically phosphoric acid, for removing the zinc oxides which have been formed on the surface of the coating layer due to the thermal treatment step; and
- a drawing step for obtaining the desired final diameter of the wire coated with brass.

Conventional methods of such type, although substantially suitable for the purpose, have nevertheless a series of drawbacks which have not been overcome yet, such as, for example, the excessive number of steps, the excessive duration of the above-mentioned diffusion step, the reduction of mechanical resistance of the wire due to said diffusion step (e.g. a reduction in the tensile strength of the coated steel wire, which reduction may be equal to 5% of the original tensile strength of the material), the irregular thickness of the brass layer, the formation of β brass having a body-centered cubic structure (which makes the drawing step extremely difficult and results in an excessive wear of the drawing dies) and the presence of areas of the wire which are not completely coated and/or which contain unacceptable amounts of impurities (such as oxides deriving not only from the acid used in the above-mentioned pickling step, but also from the oxides present in the copper plating bath and from those present in the lubricant normally used in the drawing step).

Document EP-A-1 004 689, in the name of the Applicant, discloses a method for producing a coated metal wire comprising the step of electrochemically depositing a metal coating layer onto a metal core, said metal coating layer consisting of an alloy of at least two metal components. More particularly, EP-A-1 004 689 discloses a method for producing a metal wire coated with brass in which the brass coating layer is formed by depositing - by means of an electrochemical or, in alternative, of a chemical vapor deposition technique - alternate layers of unalloyed copper and zinc on the core and then by drawing the core so coated under conditions of temperature and pressure suitable to alloy the copper and zinc to form a brass coating layer on the core. According to this method of the prior art, the outermost and the innermost layers electrodeposited are both made of copper and the required diffusion of the electrodeposited alternate copper and zinc layers to form the desired coating layer made of brass occurs during the wire-drawing operation, after the deposition of the alternate copper and zinc coating layers. Furthermore, the final brass coating layer, i.e. the brass coating layer in the drawn wire, preferably has a copper content in the outermost portion greater than the copper content in any remaining portion of the brass coating layer.

As already mentioned above with reference to the prior art methods involving an electrochemical deposition step, the technical solution disclosed by EP-A-1 004 689 presents some drawbacks which have not been overcome yet, such as the reduction of mechanical resistance of the wire, the irregular thickness of the brass layer, the formation of β brass, and the presence of areas of the wire which are not completely coated and/or which contain unacceptable amounts of impurities.

A further deposition technology which can be used to provide a metal core with a metal coating layer is the sputtering technique.

The sputtering technique essentially consists of a ionic bombardment of one or more cathodes (i.e. targets made of the material to be deposited), typically at an energy equal to about 200-500 eV, with ions of a carrier gas which is obtained under the action of an electrical field generated by applying a voltage between the cathodes and an anode (i.e. the metal core to be coated). More specifically, ions of the carrier gas are accelerated towards the cathodes, essentially causing a series of collisions with a consequent emission of cathode atoms directed towards the anode, towards which free electrons are also accelerated. The free electrons ionize by collision further atoms of carrier gas, whereby the process repeats itself and self-sustains as long as sufficient energy is supplied.

Document EP-A-0 241 721 discloses a method for continuously coating a metal core of small diameter (less than 30 µm) by means of a sputtering technique. In particular, the method disclosed by said prior art document comprises the step of coating the metal core with a metal layer of the same type of the core - i.e. either made of the same metal element of the core or of an alloy metal material sharing at least one component with the metal element of the core - and the step of drawing the coated core. The coating step is carried out by sputtering cathodes having the same composition of the coating to be obtained. In other words, when a layer made of a metal alloy material is to be deposited onto the metal core, the cathodes are made of such an alloy having the desired composition. As a result, it is necessary to change the cathodes whenever a change of coating composition of the alloy is required, with interruption of the production process and with an increase in the production costs. JP 58, 0 612 97 discloses a steel wire having an alloy coating including at least two metal components and three radial portions. The central portion has a composition different from the inner and outer portion. EP269144 A1 discloses the use of magnetron sputtering for the application of elastomer adhesion enhancing coatings to steel wires. GB-A-1 300 487 discloses a method for coating a steel wire with brass by sputtering of a cathode comprising transporting the steel wire along a path parallel to the cathode and partially lying outside the cathode both on the way to and from the cathode. The path may comprise a plurality of successive forward and backward lengths parallel to each other and spaced apart.

### Summary of the invention

In the field of coated metal wires for reinforcing elastomeric materials, comprising a metal core and a metal coating layer made of a metal alloy material including at least one first metal component and at least one second metal component, the coating layer being arranged in a radial position with respect to the metal core and in contact therewith, the market usually requires that the metal coating layer is suitable for the different kinds of elastomeric materials into which the wires have to be embedded, for example in tire manufacturing processes.

In particular, the metal alloy material of the coating layer is required to have a composition which is suitable for obtaining an adequate adhesion of the coated metal wire to the elastomeric material to be reinforced. The adhesion of the coated metal wire to the elastomeric material depends on the reactivity of the coating layer, namely of the outermost portion thereof. In order to obtain a suitable adhesion of the coated metal wire to the elastomeric material, a balance between the reactivity of the elastomeric material and the reactivity of the coating layer of the coated metal wire has to be ensured. For instance, in case the reactivity of the elastomeric material is low, it is necessary to increase the reactivity of the coating layer of the coated metal wire in order to obtain a good adhesion therebetween.

In this regard, in case, for example, a coating layer made of brass is considered, the Applicant has noted that the reactivity of the coating layer - and hence the adhesion thereof to the elastomeric material to be reinforced - depends on the thickness of an external layer made of copper (and, to a lesser extent, zinc) sulfides which forms when the tire is vulcanized, namely as a result of the reaction between the sulfur contained in the rubber mixture of the elastomeric material and the copper (and, to a less extent, zinc) contained in the coating layer of the cords reinforcing the semi-finished products constituting, for example, a tire, typically the belt layers of the tire.

In particular, with reference to such example, the thickness of such external layer made of copper sulfides has to be sufficiently high to confer a suitable degree of reactivity to the coated metal wire, but not too high to avoid brittleness, which would compromise the adhesion of the coated metal wire to the elastomeric material.

For example, in case a steel wire coated with brass is considered, the wire is normally requested to be provided with a coating layer having a copper content from 60% to 72% by weight, this percentage depending on the specific chemical reactivity of the elastomeric material to be reinforced by the steel wire.

The Applicant has observed that, according to the manufacturing methods of the coated metal wires known in the art, it is possible to modify the composition of the metal coating layer (e.g. it is possible to modify the copper content of a brass layer covering a metal core) only by modifying the conditions of deposition, fact which generally requires an interruption of the wire manufacturing process. For instance, in case the coating layer is formed by means of an electrochemical deposition technique, the composition of the metal coating layer can be modified by changing the electrolytic baths and/or by varying the electrolytic process conditions. Alternatively, in case the coating layer is formed by means of a sputtering deposition technique, the composition of the metal coating layer can be modified by substituting the cathode with a different one having the desired metal alloy composition to be deposited onto the metal core.

In view of the above, the Applicant has perceived the necessity, on the one hand, of providing a method for producing a coated metal wire which allows to modify the composition - in terms of percentage of each component thereof - of the metal alloy material of the coating layer, and in particular of the outermost portion thereof as mainly responsible for the reactivity of the coating layer, so that the reactivity of the coated metal wire can be varied with respect to the reactivity of the elastomeric material to be reinforced with said coated metal wire.

On the other hand, the Applicant has perceived the necessity of providing a method for producing a coated metal wire of indefinite length in a substantially continuous manner, i.e. without substantially interrupting the production process, and in an extremely flexible manner, so as to promptly meet the ever changing market demands in terms of composition of the metal alloy to be deposited.

The achievement of such a result of obtaining a flexible production without interrupting the production process has been one of the Applicant's objectives.

In the following description and in the subsequent claims, the expression "continuous" is used to indicate the absence, between the steps of the production method, of intermediate storages of semi-finished products, so as to continuously produce in a single production line a coated metal wire having indefinite length or a metal cord of indefinite length which is obtained by stranding together a plurality of coated metal wires.

The Applicant has further noticed that a possible modification of the composition of the metal alloy material of the coating layer could not only be exploited in regard of the outermost portion of the coating layer, which is directly responsible for the adhesion of the wire to the elastomeric material to be reinforced, but also in regard of the innermost portion of the coating layer, i.e. of the portion at the interface with the metal core. The modification of the composition of the innermost portion of the coating layer, in fact, allows to improve the corrosion resistance at the interface metal core/coating layer so that the adhesion of the wire to the elastomeric material to be reinforced is improved, particularly under aging conditions.

The Applicant has found that the result mentioned above can be attained by providing a method for producing a coated metal wire based on a sputtering deposition technique comprising the step of conveying the metal core to be coated along a predetermined path in a substantially continuous manner and by suitably configuring such path. In particular, the Applicant has found that a modification of the composition of at least one radial portion of the coating layer - in terms of percentage of each component thereof - is surprisingly possible by configuring the above-mentioned path in such a manner that at least one portion thereof lies outside the area defined by the geometrical dimensions of the cathode, namely outside the area obtained by perpendicularly projecting the cathode surface onto the plane on which the metal core path lies. In other words, the Applicant has found that a modification of the composition of at least one radial portion of the coating layer is possible by providing a sputtering step which is carried out at least partially outside the area obtained by perpendicularly projecting the cathode surface onto the plane on which the metal core path lies. As a result, at least one radial portion of the coating layer is formed by the atoms emitted by the cathode along an incident direction which is inclined with respect to a direction normal to the cathode.

This modification of the composition conveniently does not involve any interruption of the manufacturing process of the coated metal wire, but only needs an appropriate change in the configuration of the path of the metal core to be coated.

More in particular, the Applicant has found that the portion of the coating layer formed by the atoms emitted by the cathode impinging on the metal core when the latter is conveyed outside the area defined by the geometrical dimensions of the cathode is surprisingly enriched in one of the metal components of the metal alloy material. In other words, the Applicant has found that the reactivity of at least one radial portion of the coated metal wire can be modified without interrupting the wire manufacturing process (e.g. for providing a cathode of a desired different composition as required by the prior art methods) by suitably selecting the incident angle of the atoms of metal alloy material emitted by the cathode and impinging on the metal core.

By way of illustrative example, the Applicant has found that, by using a cathode made of brass having a copper content of about 60% by weight, it is possible to deposit onto the metal core a coating layer made of brass having at least one radial portion including a copper content varying from about 60% to about 68% by weight with respect to the remaining portion of the coating layer by varying the path portion of the metal core lying outside of the area defined by the geometrical dimensions of the cathode, i.e. by varying the inclination angle of the incident direction of the atoms emitted by the cathode from about 0° to about 75° with respect to the incident direction normal to the cathode.

Therefore, the method of the present invention allows to produce a coated metal wire whose coating layer composition, in particular the composition of at least one radial portion thereof, e.g. the outermost and/or the innermost portion, can be varied without interrupting the manufacturing process to adjust the reactivity of the coating layer on the basis of the reactivity of any desired elastomeric material.

In accordance with a first aspect thereof, the present invention relates to a method for producing a coated metal wire comprising a metal core and a coating layer made of a metal alloy material including at least one first metal component and at least one second component according to claim 1.

In the following description and in the subsequent claims, the expression "cathode" (or "magnetron") is used to indicate an assembly comprising the coating material (which is the target, preferably in the form of a plate) and a plurality of magnets which are arranged below the coating material and which create a magnetic trap for the charged particles - e.g. argon ions - in front of the coating material. Furthermore, since the sputtering process causes the heating of the coating material, generally the cathode further comprises a cooling system, typically a plurality of channels for the passage of cooling water thereinto.

In the following description and in the subsequent claims, the expression "in proximity of at least one cathode" is used to indicate an arrangement of the path of the metal core according to which the metal core is conveyed at a useful sputtering distance from the cathode, i.e. neither too far away from nor too close to the cathode in order to avoid an incomplete and/or an inhomogeneous coating of the core.

Thanks to these steps, it is advantageously possible to produce in a continuous manner a metal wire comprising a metal core and a coating layer made of a metal alloy material including at least one radial portion (e.g. the radially outermost and/or innermost portion, i.e. the portion(s) of the coating layer mainly responsible for the adhesion of the coating layer to the material to be reinforced) having a desired composition which can be varied within a certain range. In order to obtain a desired composition of the radially outermost portion of the coating layer, for example, it is sufficient to arrange the final portion of the path (i.e. the portion of path at which the metal core receives the final coating) outside the above-mentioned volume, while in order to obtain a desired composition of the radially innermost portion of the coating layer, it is sufficient to arrange the initial portion of the path (i.e. the portion of path at which the metal core receives the initial coating) outside the above-mentioned volume.

In this way, in order to meet the ever changing market demands, whenever it is required to change the composition of at least one portion of the metal alloy material, for example the composition of the metal alloy forming the radially outermost portion of the coating layer, from a first to a second composition in order to adjust the reactivity of the coated metal wire as a function of the type of elastomeric material to be reinforced, it is necessary to modify the path of the metal core with respect to the cathode, namely the portion of the path lying outside the area defined by the perpendicular projection of the cathode onto the plane containing the metal core path or, in other words, to modify the above-mentioned incident angle of the atoms emitted by the cathode as a function of the desired composition of the metal alloy.

For example, starting from a first batch of production with a metal core coated with a layer made of brass having a first composition, it is advantageously possible to pass to a second batch of production with a metal core coated with a layer made of brass comprising at least a radially outer portion having a second composition, different from the first composition, by suitably increasing or reducing the length of the final portion of the path along which the metal core is conveyed lying outside the above-mentioned area. In this way, during the final step of the sputtering action, the angle defined between the normal to the cathode and the radial vector representing the beam of metal alloy directed towards the portion of the metal core arranged outside of the above-mentioned volume is increased or, respectively, reduced.

In particular, a suitable increase of the portion of the path lying outside the above-mentioned area or, in other terms, a suitable increase in the deviation of the brass beam emitted towards the metal core with respect to the normal to the brass cathode, implies a corresponding increase in the amount of copper deposited by sputtering onto the metal core, thus allowing to produce a metal wire coated with a brass layer having a higher reactivity.

In this way, with a cathode having a first composition of brass, it is advantageously possible to obtain a metal wire coated with a brass layer comprising at least a radially outer portion having a second composition different from said first composition, said second composition including a copper content up to 8% higher with respect to the copper content present in the remaining portion of the brass layer.

Furthermore, as mentioned above, it is also advantageously possible to modify the composition of the metal alloy material of the innermost portion of the coating layer, i.e. the portion of coating layer at the interface with the metal core. In order to obtain a desired composition of the radially inner portion of the coating layer, in fact, it is sufficient to arrange the initial portion of the path (i.e. the portion of the path at which the metal core is initially coated) outside the above-mentioned volume.

In this way, the corrosion resistance of the coating layer, particularly under aging conditions, may be advantageously increased, thereby increasing the adhesion of the wire to the elastomeric material to be reinforced. Additionally, the adhesion of the coating layer to the metal core, which in turn affects the adhesion of the whole wire to the elastomeric material to be reinforced, may also be advantageously adjusted as a function of metallic material of which the metal core is made.

Furthermore, thanks to the fact that the coating layer is deposited by means of a sputtering technique, according to which the vaporization of the material to be deposited is activated by a plasma, it is advantageously possible to obtain a metal wire comprising a coating layer whose radial portion(s) is (are) uniform and homogeneous. Such characteristics of uniformity and homogeneity of the coating layer are particularly important for the purposes of providing the metal wire with a desired corrosion resistance.

Furthermore, the sputtering deposition technique allows to obtain a coating layer having a crystalline structure conveniently deformable in a subsequent drawing step, as described in more detail in the following of the present description. More particularly, if the coating layer is made of brass, the sputtering deposition technique allows to obtain a layer of brass having a crystalline structure consisting of α brass (face-centered cubic). The deformability of α brass facilitates a subsequent drawing step to be carried out and ensures a remarkable reduction of the wear of the drawing dies to be used in the drawing step.

Thanks to the provision of the sputtering deposition technique, the amount of impurities, such as for example oxides, present in the coating layer is advantageously remarkably reduced with respect to the amount present in wires produced by the electrodeposition methods of the prior art.

In order to obtain a coating layer including at least one radial portion enriched in at least one component of the metal alloy, the inclination angle of the incident direction of the atoms emitted by the cathode may be increased from about 0° (i.e. perpendicularly to the surface of the emitting cathode) to about 75° with respect to the incident direction normal to cathode, more preferably between about 30° and about 75° and, still more preferably, between about 45° and about 70°.

Preferably, the above-mentioned path along which the metal core is conveyed lies on a plane arranged substantially parallel to said at least one cathode.

In this case, since the distance between the cathode and the metal core is substantially constant, the deposition conditions are substantially the same at each point of the metal core path as long as the metal core to be coated is conveyed inside the volume defined by a generatrix substantially perpendicular to a contour line of the at least one cathode, so that the resulting coating layer is uniform, homogeneous and has a metal alloy composition substantially identical to that of the cathode.

According to a preferred embodiment of the method of the invention, in order to obtain at least one radial portion of coating layer of the metal alloy having a predetermined composition, the above-mentioned path comprises at least one portion lying outside of the above-mentioned volume. In other words, the path includes at least a first portion arranged within the area defined by the perpendicular projection of the cathode onto the plane containing the metal core path and a second portion arranged outside the above-mentioned area.

In other words, the portion of metal core coated while being conveyed outside of the area obtained by perpendicularly projecting the cathode onto the plane on which the metal core path lies, receives a beam of metal alloy along an incident direction which is inclined by a predetermined angle with respect to the normal to the cathode.

Preferably, the ratio between the length of the path portion protruding with respect to the cathode (i.e. protruding from the cathode contour) and the distance between the at least one cathode and the metal core to be coated is comprised between about 1.5 and about 3.2.

Thanks to such preferred feature, it is advantageously possible to enrich in a metal component, such as for example copper in case the coating layer is made of brass, at least one radial portion of the coating layer.

According to a preferred embodiment of the method of the invention, the metal core is conveyed from an initial receiving position lying outside the above-mentioned volume to a final receiving position lying inside said volume.

In other words, the sputtered alloy metal is initially directed along an incident direction which is inclined with respect to the normal to the cathode and is finally directed along an incident direction which is substantially parallel to the normal to the cathode.

In this way, the corresponding deposited coating layer has a radially inner portion whose composition has a higher content of one metal component (e.g. copper in case the coating layer is made of brass) with respect to the content of such metal component present in the metal alloy constituting the cathode (e.g. brass), the remaining portion of the coating layer having a constant composition which is equal to the composition of the cathode.

Alternatively, the metal core is conveyed from an initial receiving position lying inside said volume to a final receiving position lying outside said volume.

In this way, the corresponding deposited coating layer has a radially outer portion whose composition has a higher content of one metal component (e.g. copper in case the coating layer is made of brass) with respect to the content of such metal component present in the metal alloy constituting the cathode (e.g. brass), the remaining portion of the coating layer having a constant composition which is equal to the composition of the cathode.

According to a further alternative embodiment of the method of the invention, the metal core is conveyed from an initial receiving position lying outside said volume to a final receiving position lying outside said volume.

In this way, the corresponding coating layer has a radially inner portion and a radially outer portion whose compositions have a higher content of one metal component (e.g. copper in case the coating layer is made of brass) with respect to the content of such metal component present in the metal alloy constituting the cathode (e.g. brass), the remaining portion of the coating layer, i.e. the radially central portion of the coating layer, having a constant composition which is equal to the composition of the cathode.

Preferably, the angle defined between the incident direction of the beam of metal alloy and the normal to the cathode is from about 0° to about 75°.

Preferably, the metal components of the coating layer are selected from the group consisting of: copper, zinc, manganese, cobalt, tin, molybdenum, iron, nickel, aluminum and alloys thereof.

Preferably, the coating layer is made of an alloy selected from the group consisting of: Cu-Zn (brass), Zn-Co, Zn-Mn, Zn-Fe, Zn-Al, Cu-Mn, Cu-Sn, Cu-Zn-Mn, Cu-Zn-Co, Cu-Zn-Sn, Zn-Co-Mo, Zn-Fe-Mo, Zn-Ni-Mo. In addition to Cu-Zn, particularly preferred alloys are Cu-Mn, Zn-Co and Zn-Mn, which provide the metal wire with a remarkable corrosion resistance.

The above-mentioned conveying step is carried out, in a manner conventional *per se*, within a sputtering unit in which at least one cathode made of the metal alloy to be deposited is provided.

According to a preferred embodiment of the method of the invention, in order to ensure a suitable production rate of the coated metal wire, the above-mentioned conveying step is preferably carried out at a speed comprised in the range from about 10 to about 80 m/min.

Preferably, the above-mentioned conveying step is carried out along a path comprising a plurality of successive forward and backward lengths parallel to each other and forming a bundle of wire lengths.

Therefore, according to said embodiment, the coating layer can be formed by sputtering the cathode onto the metal core a plurality of times. In such a way, the residence time of the metal core in the sputtering unit is advantageously increased. Preferably, the wire bundle lies on a horizontal plane.

In the following description, the term "wire bundle" is used to indicate the assembly of successive forward and backward lengths of a metal core inside the sputtering unit, said lengths - each one being preferably parallel to the other and being obtained by inverting the path of the metal core at each side of a deposition chamber provided in the sputtering unit - forming a bundle of wire lengths which are coated with a metal alloy material by means of a sputtering technique. In other words, the metal core is conveyed according to a path substantially shaped as a serpentine.

Preferably, the above-mentioned path comprises a plurality of forward and backward lengths (defining a multipassage path inside the sputtering unit), which are spaced apart from each other by a predetermined distance.

The sputtering unit may be provided with an inlet opening and an outlet opening respectively arranged either on the same side or on opposite sides of the sputtering unit.

The number of forward and backward lengths, i.e. the number of passages the metal core is subjected to inside the sputtering unit, is conveniently selected as a function of the predetermined thickness of the coating layer to be formed.

Furthermore, the distance between two adjacent lengths is selected as a function of the size of the sputtering unit, taking into account that there is a minimum value of said distance under which there might be an insufficient coating of the core wire due to the insufficient exposure of the core surface to the metal atoms emitted from the cathode. In case this distance is remarkably reduced, it may happen that some areas of the core surface are not uniformly reached by the sputtered metal alloy, thereby negatively affecting the quality of the coating layer.

According to a preferred configuration of the wire bundle, the latter lies on a horizontal plane and comprises wire lengths which are substantially parallel to the longitudinal extension of the sputtering unit. For example, in a sputtering unit having a longitudinal extension of about 5 m and a width of about 50-60 cm, the number of passages of the metal core within such unit is preferably comprised between 15 and 65, the distance between adjacent lengths being preferably comprised between about 0.2 cm and about 0.8 cm. According to such a path of the metal core in the sputtering unit, it is possible to deposit a coating layer having a thickness comprised between about 0.5 µm and about 2.0 µm onto the metal core in a deposition time comprised between about 1.0 min and about 3.0 min depending on the power provided to the cathodes.

According to an alternative configuration of the wire bundle, the latter preferably lies on a horizontal plane and comprises wire lengths which are substantially perpendicular to the longitudinal extension of the sputtering unit.

According to a further alternative configuration of the wire bundle, the latter lies on a vertical plane, which configuration is particular suitable when the sputtering unit extends in a substantially vertical manner.

According to a preferred embodiment of the method of the invention, the above-mentioned sputtering step is carried out by means of a magnetron sputtering technique involving a ionic bombardment of at least one cathode made of the desired metal alloy material.

Thanks to the effect exerted by the magnetic field created by the magnetron on the electrically charged particles, and in particular thanks to a confinement action of the electrons in proximity of the cathode and to an increase of the plasma density, the deposition rate is advantageously increased.

In order to carry out the above-mentioned sputtering step, it is possible to use a conventional sputtering unit which includes at least one vacuum deposition chamber provided with a vacuum pump - suitable for creating a predetermined pressure - and with means for supplying a carrier gas.

Preferably, said predetermined pressure is comprised between about 10⁻³ mbar and about 10⁻¹ mbar. More preferably, said predetermined pressure is in the order of 10⁻² mbar.

The sputtering step is preferably carried out by sputtering at least one first cathode and at least one second cathode which are provided in the at least one vacuum deposition chamber. Preferably, said cathodes lie on parallel planes in such a manner as to direct the metal alloy atoms emitted from the cathodes along respective first and second sputtering opposite directions.

According to a preferred embodiment of the present invention, at least one first cathode and at least one second cathode both made of a metal alloy material are arranged below and, respectively, above the horizontal plane defined by the wire bundle to be coated, the latter constituting the anode of the sputtering unit. In this case, a formation of a uniform coating layer made of said metal alloy is advantageously achieved. According to a further preferred embodiment, at least two first cathodes and at least two second cathodes all made of the same metal alloy material are arranged above and, respectively, below the horizontal plane defined by the wire bundle to be coated.

Alternatively, the sputtering step is carried out by sputtering a single cathode made of the desired metal alloy. In this case, the metal core is preferably coated on a first side, then overturned by means of a pulley in order to expose to the cathode a second opposite side of the metal core so that the latter is finally coated also on such second side. In this way, a uniform coating is advantageously obtained onto the metal core. In order to carry out this embodiment of the method of the invention, such overturning may be conveniently obtained by providing a sputtering unit with an inlet opening and an outlet opening both arranged on the same side of the sputtering unit, so as to advantageously coat both sides of the metal core with the same amount of alloy material.

When a first and a second cathode are provided in the sputtering unit on opposite sides with respect to the wire bundle, the first cathode may be made of a first metal alloy, while the second cathode may be made either of a metal component different from the components constituting the first metal alloy or of a second metal alloy different from the first metal alloy. In this way, a variety of metal alloys including more than two metal components can be deposited on the metal core.

According to the present disclosure the path of the metal core is arranged in such a manner that at least one portion of the path lies outside of the above-mentioned volume, i.e. a predetermined length of said path is provided to protrude from at least one edge of the cathode(s).

Preferably, the cathode(s) is (are) plate-shaped, more preferably in the form of rectangular or circular plate(s).

More preferably, in order to increase the productivity of the method of the invention, the sputtering step is carried out by arranging at least two first cathodes and at least two second cathodes (either all made of a first metal alloy or alternatively made of a first and of a second metal alloy) forming respective pairs of cathodes so that the cathodes of each pair are located on opposite sides with respect to the wire bundle, and by depositing the metals onto the metal core along respective first and second opposite sputtering directions. Preferably, the cathodes are arranged according to a substantial quadrilateral configuration which substantially surrounds the wire bundle.

In an analogous manner to the embodiment according to which a single cathode is used, each pair of cathodes preferably comprises two planar cathodes arranged on a plane substantially parallel to the metal core to be coated. In this case, in accordance with the invention, the path is arranged in such a manner that at least one portion of the path lies outside of a volume defined by a generatrix substantially perpendicular to a contour line of the assembly of cathodes, thus protruding with respect to at least one cathode of a predetermined length.

Still more preferably, in order to further increase the productivity of the method of the invention, the sputtering step is carried out by longitudinally arranging along the wire bundle a plurality of groups of cathodes, each of such groups consisting of two pairs of first and second cathodes as described above which are preferably arranged as disclosed above. Preferably, each group of cathodes consists of four cathodes which are arranged according to a substantial quadrilateral configuration which substantially surrounds the wire bundle.

A preferred embodiment of the method of the present invention provides that the sputtering step is carried out in a simultaneous manner on a plurality of metal cores which are conveyed - along a predetermined conveying direction - inside the sputtering unit. According to said embodiment, the productivity of the method can advantageously be further increased.

According to a further preferred embodiment, the method of the invention comprises the steps of providing a first vacuum deposition chamber and a second vacuum deposition chamber which are arranged in series, and of depositing the metal alloy material in at least one of said vacuum deposition chambers by conveying the metal core to be coated in succession through said vacuum deposition chambers.

According to said embodiment, the sputtering step is carried out only in one vacuum deposition chamber while the second one is set to a stand-by mode. In such way, when the cathodes of the operative chamber are totally consumed and new cathodes have to be provided, the production method does not need to be interrupted since the sputtering step can be performed in the second chamber which is switched to an operative mode while the first chamber is put in a stand-by mode. This results in an advantageous increase of the productivity of the method of the invention. Generally, the vacuum deposition chamber which is operative is at a first predetermined pressure suitable for carrying out the sputtering step.

Preferably, said sputtering step is carried out until a predetermined initial thickness of said coating layer is attained, the expression "initial thickness" being used to indicate the thickness obtained after the sputtering step and before any possible further step provided downstream of the sputtering step.

If the reactivity of the coating layer is adjusted by correspondingly adjusting the content of one metal component present in the radially outermost portion of the coating layer, the initial thickness of the radially outermost portion of the coating layer is preferably about 3-10% of the initial thickness of the whole coating layer.

By way of illustrative example, the method of the invention allows to deposit on a metal core a coating layer having a suitable initial thickness in the order of some microns, preferably comprised between about 0.5 µm and about 3.0 µm, the outer coating layer having an initial thickness preferably comprised between about 0.015 µm and about 0.3 µm.

Preferably, the method of the invention further comprises the step of conveying the metal core into at least one pre-chamber which is subjected to a second predetermined pressure which is higher than said first predetermined pressure, said at least one pre-chamber being arranged upstream of said at least one vacuum chamber.

In such way, the desired vacuum condition is advantageously achieved in at least two subsequent steps, i.e. in a stepwise manner, which is simpler and more convenient from an economical point of view than the achievement of a vacuum condition in a single step.

Furthermore, the provision of at least one pre-chamber advantageously allows to preserve the vacuum deposition chamber (in which the sputtering step is carried out) from the contamination of dusts and external agents in general, such as oxygen, which are detrimental to the effectiveness of the formation of the coating layer and to the purity thereof.

Such advantageous effect can be achieved by introducing in the at least one pre-chamber a flow of a chemically inert gas. Preferably, the at least one pre-chamber contains the same gas used as carrier gas in the at least one vacuum deposition chamber, thus allowing to use a supply of gas of the same type both for the pre-chamber and for the vacuum deposition chamber.

More preferably, the above-mentioned chemically inert gas is argon, which is convenient from an economical point of view, thus resulting in a reduction of the production costs.

Preferably, a further pre-chamber subjected to the above-mentioned second predetermined pressure is provided downstream of the at least one vacuum deposition chamber.

Preferably, said second predetermined pressure is comprised between about 0.2 and about 10 mbar, more preferably between about 2.0 and about 5.0 mbar and, still more preferably, in the order of about 0.5-1.0 mbar.

According to a further preferred embodiment thereof, the method of the invention comprises the step of providing a first vacuum deposition chamber and a second vacuum deposition chamber arranged in series as described above, the first vacuum deposition chamber being arranged downstream of a first pre-chamber as described above and the second vacuum deposition chamber being arranged downstream of a second pre-chamber separating the two vacuum deposition chambers, a third pre-chamber being arranged downstream of the second vacuum deposition chamber.

According to a preferred embodiment of the method of the invention, the metal core has a predetermined initial diameter and the sputtering step is carried out until a predetermined initial thickness of the coating layer is attained. The method further comprises the step of drawing the coated metal core until the metal core has a final diameter smaller than said predetermined initial diameter and the coating layer has a final thickness smaller than said predetermined initial thickness.

In the following description and in the subsequent claims, the expressions "initial diameter of the core" and "initial thickness of the coating layer" are used to indicate the diameter of the metal core and, respectively, the thickness of the coating layer before the drawing step is carried out.

In the following description and in the subsequent claims, the expressions "final diameter of the core" and "final thickness of the coating layer" are used to indicate the diameter of the metal core and, respectively, the thickness of the coating layer after the drawing step is carried out.

Preferably, the drawing step is carried out in an emulsion bath which comprises a predetermined amount of a lubricating agent, for example a lubricating oil conventional *per se*, so that the drawability of the wire is advantageously improved.

More preferably, the lubricating agent is selected from the group consisting of: phosphorous containing compounds (e.g. organic phosphates), sulfur containing compounds (e.g. thiols, thioesters, thioethers), chlorine containing compounds (e.g. organic chlorides). Preferably, said lubricants are the so-called "Extreme Pressure Lubricants", i.e. lubricants which decompose at high temperature and pressure (e.g. giving rise to the formation of phosphides, sulfides and chlorides of iron, copper or zinc).

Preferably, the step of drawing the coated wire is carried out by means of drawing dies made of tungsten carbide or of diamond, which are conventional *per se*.

Furthermore, thanks to the fact that the coating layer is deposited by a sputtering technique, the percentage variation of the amount of said lubricating agent in said coating layer is lower than about 1% by weight, more preferably comprised between about 0.01% and about 1% by weight, in the radial direction of the wire with respect to the weight of the metal alloy forming the coating layer.

In an analogous manner, the percentage variation of the amount of said lubricating agent in said coating layer is lower than about 1% by weight, more preferably comprised between about 0.01% and about 1% by weight, in the axial direction of the wire with respect to the weight of the metal alloy forming the coating layer.

Preferably, the drawing step is carried out in such a way as to obtain a metal core having a final diameter which is reduced of about 75-95% with respect to the initial diameter thereof, more preferably of about 80-90% and, still more preferably, of about 85% with respect to the initial diameter.

In accordance with a preferred embodiment of the method of the invention, the drawing step is carried out in such a way as to obtain a coating layer having a final thickness which is reduced of about 75-95% with respect to the initial thickness thereof, more preferably of about 78-88% and, still more preferably, of about 83% of the initial thickness.

Preferably, the initial diameter of the metal core is comprised between about 0.85 mm and about 3.00 mm and the drawing step is carried out in such a way as to obtain a metal core having a final diameter comprised in the range 0.10-0.50 mm.

Preferably, the initial thickness of the coating layer is at least about 0.5 µm. More preferably, the initial thickness of the coating layer is comprised between about 0.5 and about 3 µm and, still more preferably, between about 0.5 and about 2 µm.

In such a way, a suitable value of the initial thickness of the coating layer in view of the drawing step of the coated metal core is obtained, which allows to obtain the desired value of final diameter of the core and an advantageous increase of the properties of mechanical resistance of the wire. For illustrative purposes, a wire having an initial breaking load - i.e. before the drawing step of the coated core - equal to about 1200 MPa can reach - due to the drawing step of the coated core - a final breaking load of about 3200 MPa.

Preferably the drawing step is carried out in such a way as to obtain a coating layer having a final thickness comprised in the range 80-350 nm.

If the initial thickness of the radially outer portion is comprised from about 50 to about 150 nm, after the drawing step the final thickness of said portion is comprised in the range 25-75 nm.

For example, in the case a brass layer has to be deposited, if the copper content of the radially outer portion of the coating layer is of about 1-8% higher than the copper content of the remaining portion of the coating layer, after the drawing step the copper content of the radially outer portion of the coating layer is of about 0.5-3% higher than the copper content of the remaining portion of the coating layer.

Additional manufacturing methods for producing a metal cord as final product by using the coated core as starting product may be carried out. By way of illustrative example, in order to produce a metal cord comprising a plurality of coated metal wires, a stranding step of said plurality of coated metal wires may be provided after the drawing step is carried out on the coated cores.

The method of the present invention may optionally also include one or more preliminary steps aimed at obtaining a metal core of a predetermined diameter starting from a wire rod.

For example a mechanical removal of the oxides present on the wire rod, known in the field with the term of descaling, may be carried out. The descaling step is carried out to smooth the wire rod, i.e. to substantially eliminate the roughness thereof. In such way, any surface roughness, which may have a remarkable depth in the case of a rod made of steel, typically in the range of from about 1.5 µm to 2.0 µm, is advantageously eliminated, thus improving the adhesion of the coating layer to the core in the successive depositing step and the effectiveness of the deposition step. The descaling step is preferably followed by a dry drawing of the wire rod, at the end of which a metal core having a predetermined initial diameter is obtained.

Subsequently to these preliminary steps, according to a preferred embodiment of the method of the invention, the metal core undergoes a surface treatment which is aimed to remove oxides possibly present on the metal core surface. The surface treatment preferably comprises the steps of pickling, washing and optionally drying the metal core. The pickling step is carried out by introducing the metal core into a pickling bath, such as for example a bath containing sulfuric acid. Successively, the pickled core is washed by means of water and optionally dried, preferably by means of hot air produced by a blower (e.g. at a temperature from about 70°C to about 90°C, more preferably at a temperature of about 80°C).

Alternatively to the pickling step, the core may undergo alternative surface treatments, such as for example etching, cleaning and activation by a plasma etching technique, for example by conveying argon ions onto the core surface.

According to an alternative embodiment of the method of the invention, the above-mentioned surface treatment, such as for example the pickling or any other alternative treatment suitable for the purpose, may be carried out on a wire rod, preferably preliminarily descaled, and the surface treatment is followed by a dry drawing aimed at obtaining a metal core having a predetermined initial diameter.

The metal core is preferably superficially treated according to one of the above-mentioned procedures before being coated so as to predispose the surface of the metal core to being coated, i.e. to obtain a metal core suitable for uniformly receiving the coating layer on the whole surface thereof. Thanks to this preliminary treatment, it is advantageously possible to obtain a metal wire of improved quality. In other words, any macrorugosity or unevenness of the core surface is advantageously substantially eliminated, thus rendering the core surface suitable for the deposition of the coating layer thereon.

Preferably, the metal core is also thermally treated before being coated, so as to advantageously obtain a structure suitable for a cold deformation, such as the deformation involved in the above-mentioned optional drawing step. Preferably, the thermal treatment - which is carried out to cause annealing of the metal - consists in a patenting thermal treatment which may be carried out in a furnace.

In the case steel is concerned, the patenting step is aimed to provide the steel core with a pearlitic structure which has a very high work-hardening coefficient and thus can be easily drawn.

By way of indication only, said thermal treatment of the metal core preferably comprises the step of gradually heating the core to a predetermined temperature, such as for example comprised between about 900°C and about 1050°C for a time of about 20-40 s, and the subsequent step of cooling the core to a predetermined temperature, such as for example comprised between about 520°C and about 580°C for a time of about 5-20 s. Preferably, the cooling step is carried out by introducing the metal core into a molten lead bath. Alternatively, the cooling step is carried out by introducing the metal core into a bath of molten salts (i.e. chlorates, carbonates), by passing the metal core through zirconium oxide powders or by means of air.

According to a preferred embodiment, the method of the invention further comprises the step of dry drawing the core before the above-mentioned thermal treatment, preferably in such a manner to obtain a slight reduction of the core diameter, such as for example comprised between about 1% and about 3%.

The method of the present invention preferably further comprises an additional thermal treatment, which is preferably carried out at the same working conditions mentioned above and which comprises an additional gradual heating step and a subsequent cooling step of the metal core.

When a first and a second thermal treatment are provided, a further dry drawing is preferably carried out after the first thermal treatment. If additional thermal treatments are provided, a dry drawing between each couple of thermal treatments is preferably carried out.

When a single thermal treatment is provided, a further slight dry drawing is preferably carried out by using a drawing die which is preferably connected in an gas-tight manner with the vacuum deposition chamber, at the inlet thereof. More preferably, such slight drawing step may be carried out by means of a so-called split drawing die, which essentially comprises a drawing die having two symmetrical halves. Thanks to this feature, the drawing die may be advantageously substituted in a simple manner, without interrupting the production method.

The above-mentioned conveying and sputtering steps, as well as any of the optional surface treatment, thermal treatment, and drawing steps of the method of the invention, are preferably carried out in a substantially continuous manner, without any substantial interruptions between two subsequent steps.

In such a way, it is advantageously possible to obtain a metal wire coated with a metal coating layer having a desired thickness by means of a production method which is carried out in a continuous manner from the step of producing the metal core of the wire to the optional step of drawing the coated core, optionally including additional conventional preliminary treatments effected on the core or additional finishing treatments effected on the coated core (e.g. a phosphating treatment of the core or of the coated core in order to improve the drawing thereof).

In accordance with a second aspect thereof, the present invention relates to a coated metal wire - which can be used for reinforcing elastomeric materials according to claim 13.

Preferably, the above-mentioned first composition is equal to the above-mentioned third composition.

Preferably, the metal alloy is brass.

In case the coating layer is made of brass, the radially inner portion and the radially outer portion have a copper content from about 1% to about 8% - preferably from about 2% to about 5% - by weight higher than the copper content of the central portion.

Thanks to such a feature, namely thanks to the protection conferred by copper, which is electrochemically nobler than steel, within such preferred range, an improved corrosion resistance of the wire is attained. The attainment of this improved corrosion resistance, in turn, advantageously allows to obtain an improved adhesion between the wire and the elastomeric material to be reinforced, particularly under aging conditions.

In case the coating layer is made of brass, the central portion preferably has a copper content of 60 to 72%. More preferably, the central portion preferably has a copper content of about 64 to about 67% by weight.

Preferably, the core is made of steel, which advantageously allows to confer an improved mechanical resistance to the wire, which property is particularly desired when the wire is intended to reinforce elastomeric materials used to manufacture a tire.

Preferably, the coating layer is deposited by means of a sputtering technique performed until a predetermined initial thickness of said coating layer is attained, said radially outermost portion of coating layer having an initial thickness of about 3-10% of the total initial thickness of the coating layer, and said radially innermost portion of coating layer having an initial thickness of about 3-10% of the total initial thickness of the coating layer.

Preferably, the initial thickness of said coating layer is comprised between about 0.5 and about 3 µm. More preferably, the initial thickness of said coating layer is comprised between about 0.5 and about 2 µm.

Preferably, said coated metal wire is submitted to a drawing step until a coating layer having a final thickness by about 75-95% with respect to the initial thickness thereof is obtained.

Preferably, the metal coating layer is provided with a predetermined amount of phosphorous so that the drawability of the wire is advantageously improved without affecting the adhesion of the coating layer to the elastomeric material in which the coated wire is intended to be embedded. This effect may be accomplished, for instance, by including a predetermined amount of phosphorous in at least one of the cathodes.

Preferably, the coating material comprises phosphorous in an amount of about 1-3% by weight, more preferably in an amount of about 2% by weight, with respect to the total weight of the coating metal.

Advantageously, by including phosphorous in such preferred amount in the metal components to be deposited onto the metal core, the sputtering step allows to deposit a brass layer comprising phosphorous exactly in the same amount (i.e. 1-3%) in an uniform manner. Therefore, since phosphorous is uniformly present in the whole thickness of the coating layer, the subsequent drawing step is improved thanks to the lubricating action of the phosphorous, independently of the drawing degree which has been set.

In order to produce a coated metal wire as described above, an apparatus may be used comprising:
a) at least one sputtering unit;
b) at least one device for conveying in a substantially continuous manner the metal core along a predetermined path within said sputtering unit;
c) at least one first cathode arranged within said sputtering unit, the at least one cathode being made of a metal alloy including at least one first metal component and at least one second metal component.

The sputtering unit is preferably a magnetron sputtering unit since this technique advantageously increases the deposition rate of the metal layer essentially thanks to the effect exerted on the electrically charged particles by a magnetic field, the latter inducing a confinement action on the electrons in proximity of the cathode(s) and thus increasing the plasma density.

Preferably, the conveying device comprises at least one device for feeding the metal core into the sputtering unit along a respective first forward length and at least one counter-device for feeding back the metal core along a respective backward length, the backward length being spaced apart with respect to the forward length by a predetermined distance. In this manner, the residence time of the metal core in the sputtering unit is advantageously increased.

The present invention further relates to a method for producing a metal cord for reinforcing an elastomeric material, as well as to a metal cord of such type, said method comprising the steps of producing a plurality of metal wires coated by means of the method described above and the subsequent step of stranding together said plurality of coated metal wires.

In order to produce a metal cord of the above-mentioned type, an apparatus comprising, in addition to the components of the apparatus mentioned above with reference to the production of a coated metal wire, a device for stranding a plurality of coated metal wires, may be used.

### Brief description of the drawings

Additional features and advantages of the invention will become more readily apparent from the description of some preferred embodiments of a method according to the invention for producing a coated metal wire comprising a metal core and a coating layer made of a metal alloy material including at least one first component and at least one second component, made hereafter with reference to the attached drawing in which, for illustrative and not limiting purposes, a preferred embodiment of an apparatus for producing a coated metal wire of the above-mentioned type is represented.

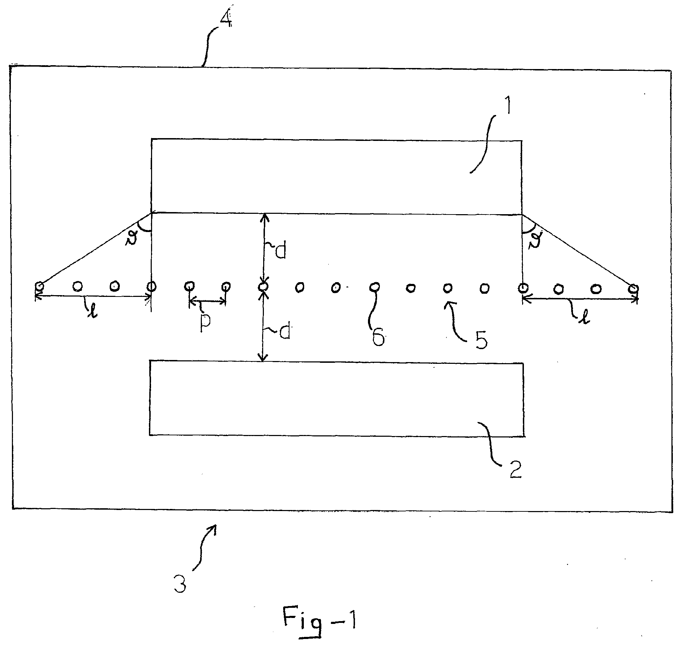

In detail, figure 1 is a schematic cross-sectional view of a preferred embodiment of an apparatus for producing a coated metal wire comprising a metal core and a coating layer made of a metal alloy material.

### Detailed description of the preferred embodiments

A first preferred embodiment of the process of the present disclosure is described with reference to the apparatus illustrated in figure 1, wherein a preferred cathode configuration is shown.

As it will be more apparent from the following, the method advantageously allows to obtain a metal wire including a metal core and a coating layer made of a metal alloy material including at least one first metal component and at least one second metal component, the coating layer comprising a radially inner portion, a radially outer portion and a central portion arranged between the radially inner portion and the radially outer portion, wherein both the radially inner portion and the radially outer portion are made of such metal alloy having a first composition and the central portion is made of such metal alloy having a second composition different from the first composition. By way of illustrative example, a preferred embodiment of the method will be described hereafter which is intended to produce a wire including a steel core and a coating layer made of brass in which each of the radially outer and inner portion preferably includes a copper content of about 1% to about 8% with respect to the central portion of the coating layer. As will be more readily apparent from the following, this effect is achieved by arranging two portions of the path, along which the steel core is conveyed, outside of a volume defined by a generatrix substantially perpendicular to a contour line of at least one cathode made of brass.

With reference to figure 1, a first cathode 1 and a second cathode 2, both made of brass, are arranged parallel to each other within a magnetron sputtering unit 3 comprising a vacuum deposition chamber 4 (which is subjected to a first predetermined pressure), and first and second pre-chambers (not shown) both subjected to a second predetermined pressure higher than said first predetermined pressure. The first and the second pre-chambers are arranged upstream and, respectively, downstream of the vacuum deposition chamber 4.

In figure 1, the first cathode 1 and the second cathode 2 have a plate-shaped form and are arranged above and, respectively, below a steel core 6 to be coated.

The cathodes 1, 2 are at a predetermined distance d from the steel core 6.

In order to increase the productivity, a plurality of cathodes 1 and a corresponding plurality of opposite cathodes 2 - all made of brass having the above-mentioned composition - are successively arranged along the longitudinal development of the vacuum deposition chamber 4 of the magnetron sputtering unit 3.

The magnetron sputtering unit 3 further comprises a device (not shown since it is conventional *per se*) for conveying the steel core 6 along a predetermined path in a substantially continuous manner.

In particular, the conveying device comprises: a) a plurality of devices for feeding the steel core 6 into the magnetron sputtering unit 3, along a respective plurality of forward lengths, and b) a plurality of counter-devices for feeding back the steel core 6, along a respective plurality of backward lengths, the backward lengths being spaced apart with respect to the forward lengths by a predetermined distance p. Such plurality of devices and counter-devices are not shown as conventional *per se.* For example, such devices and counter-devices may comprise pulleys and respective counter-pulleys which are arranged on opposite sides of the magnetron sputtering unit 3.

In this manner, the steel core 6 forms a wire bundle 5 comprising a plurality of successive forward and backward wire lengths substantially parallel to the longitudinal extension of the magnetron sputtering unit 3, which advantageously increases the residence time of the steel core 6 inside the vacuum deposition chamber 4. In the embodiment shown in figure 1, the wire bundle 5 lies on a horizontal plane which is parallel to the cathodes 1, 2 and is equally spaced apart from the cathodes 1, 2 of the above-mentioned distance d.

As described above, each forward length is spaced apart with respect to the adjacent backward length by the distance p. For a vacuum deposition chamber 4 having a width of about 25 cm - in which a steel core 6 having a diameter of 1.40 mm is conveyed according to a path consisting of 45 passages - a suitable value of the distance p between the adjacent lengths of the steel core 6 is of about 5 mm.

According to the invention, in order to obtain both a radially inner and a radially outer portion of the coating layer having a copper content higher than the copper content of the central portion of the coating layer, the above-mentioned path is arranged in such a manner that two portions of the path (an initial portion and a final portion) along which the steel core 6 is conveyed lie outside of a volume defined by a generatrix substantially perpendicular to a contour line of the cathodes 1 and 2.

More in particular, according to the preferred embodiment shown in figure 1, the wire bundle 5 protrudes with respect to the axial edges of both the cathodes 1, 2 of a same predetermined length 1, which in the embodiment shown in figure 1 is of about 7.5 cm. More particularly, in such preferred embodiment the wire bundle 5 protrudes with respect to both the cathodes 1 and 2 of such length 1 in such a manner that an angle θ, preferably comprised between 45° and about 70°, is defined between the normal to the cathodes 1 and 2 and the radial vector representing the beam of atoms emitted by the cathodes 1, 2 towards the portions of the steel core 6 present in the wire bundle 5 protruding with respect to the cathodes 1 and 2.

In order to obtain a copper content of both the radially outer portion and the radially inner portion higher than about 4% with respect to the copper content present in the central portion of the coating layer, the angle θ is preferably of about 69°.

Generally, the value of the angle θ is selected as a function of the desired brass composition of the radially outermost portion of the coating layer, which in turn is selected as a function of the reactivity of the elastomeric material which has to adhere to said coating layer.

According to the preferred embodiment shown in figure 1, the angle θ has the same value for both the radially inner and the radially outer portion, so that said portions have the same copper content.

A preferred embodiment of the method of the invention for producing a coated steel wire comprising a steel core 6 and a coating layer made of brass is described in the following.

The method may include a series of preliminary steps aimed at obtaining a steel core 6 of a predetermined diameter starting from a wire rod and a series of preliminary treatments performed on the steel core 6, such as for example a superficial treatment so as to eliminate any macrorugosity of the steel surface in order to improve the adhesion of the brass layer to the steel core 6, as well as a thermal treatment so as to obtain a pearlitic structure which is more suitable for the successive cold deformation during the drawing step.

According to said method, the steel core 6 is firstly conveyed along the above-mentioned predetermined path in a substantially continuous manner, for example at a speed comprised in the range from about 10 to about 80 m/min.

In a second step of the method, the cathodes 1 and 2 made of brass are sputtered onto the steel core 6, preferably in a substantially simultaneous manner.

Preferably, the sputtering step is carried out by setting a pressure in the order of 10⁻³ - 5·10⁻² mbar in the vacuum deposition chamber 4, a voltage applied to the electrodes comprised between about 100 and about 1000 V and a current comprised between about 0.1 and about 10 A. The sputtering step essentially consists of a ionic bombardment of the cathodes 1, 2 with ions of the carrier gas obtained under the action of an electrical field generated by applying the voltage mentioned above. More specifically, ions of the carrier gas are accelerated towards the cathodes 1, 2, essentially causing a series of collisions with a consequent emission of atoms of the cathodes 1, 2 directed towards the anode, i.e. towards the steel core, towards which free electrons are also accelerated. The free electrons ionize by collision further atoms of carrier gas, whereby the process repeats itself and self-sustains as far as sufficient energy is supplied.

By complying with the above-mentioned preferred voltage, current and gas pressure values, a deposition rate of brass comprised in the range from about 100 to about 1000 nm/min, depending on the distance d between the cathodes 1, 2 and the steel core 6, is advantageously achieved. A distance d between the cathodes 1, 2 and the steel core 6 ranging from about a few cm to some tens of cm - as a function of the size of the cathodes 1, 2 - has been found particularly preferred in terms of effectiveness of deposition. For example, with a distance d of about 3 cm, the deposition rate is of about 800 nm/min.

The sputtering step is carried out until a predetermined initial thickness of the brass coating is obtained, such as for example comprised between about 0.5 and about 3.0 µm.

Two portions, an initial portion and a final portion, of the above-predetermined path along which the steel core 6 is conveyed lie outside of a volume defined by a generatrix substantially perpendicular to a contour line of the cathodes 1, 2, so that the respective portions of the coating layer formed outside of such volume are both made of brass having a second composition different from the first composition.

More particularly, according to the embodiment shown in figure 1, two portions of the above-predetermined path along which the steel core 6 is conveyed lie outside of a volume defined by a generatrix substantially perpendicular to a contour line of the cathodes 1, 2, so that the portions of coating layer formed outside of such volume are made of brass having a second composition different from the first composition.

In other words, thanks to this arrangement of the path along which the steel core 6 is conveyed, the steel core 6 receives respective beams of brass atoms intended to form a radially inner and a radially outer portion of the coating layer along respective incident directions each inclined of the predetermined angle θ with respect to the normal to the cathodes 1 and 2, thus allowing to change the copper content of the radially inner and of the radially outer portion of the coating layer with respect to the copper content of the central portion of the coating layer. More particularly, the steel core 6 is conveyed successively from an initial receiving position at which brass is sputtered along an incident direction which is inclined of the angle θ with respect to the normal to the cathodes 1, 2 to an intermediate receiving position - i.e. a position at which the steel core 6 is conveyed within the above-mentioned volume defined by the arrangement of the cathodes 1, 2 - at which brass is sputtered along an incident direction which is substantially parallel to the normal to the cathodes 1, 2 and, finally, to a final receiving position at which brass is sputtered along an incident direction which is inclined of the same angle θ with respect to the normal to the cathodes 1, 2.

According to the embodiment shown in figure 1, the radially outer portion of the coating layer can be provided with a thickness of about 50-100 nm depending on the conveying rate to which the steel core 6 is submitted. In a similar manner, the radially inner portion of the coating layer can be provided with a thickness of about 50-100 nm depending on the conveying rate to which the steel core 6 is submitted.

In a further step of the preferred embodiment of the method of the present invention, the coated core is drawn until the steel core 6 has a final diameter smaller than a predetermined initial diameter and the brass layer has a final thickness smaller than a predetermined initial thickness.

For example, the initial diameter of the steel core 6 is comprised between about 0.85 mm and about 3 mm and the drawing step is carried out in such a way as to obtain a steel core 6 having a final diameter comprised in the range from 0.10 to 0.50 mm.

Preferably, the drawing step of the coated core is carried out in an emulsion bath, for example containing a lubricating oil, and is carried out by drawing dies which are preferably made of tungsten carbide.

At the end of such a drawing step, a steel wire uniformly and homogeneously coated with a brass coating layer is obtained.

All the steps of the method of the invention are preferably carried out in a substantial continuous manner.

Further preferred embodiments of the method of the invention may be envisaged without departing from the scope of the attached claims. For example, in order to avoid any interruption in the sputtering process due to the consumption of the brass cathodes, the sputtering step may be carried out in a first vacuum deposition chamber, a second vacuum deposition chamber being arranged in series with the first one and being set in a stand-by mode. In the second vacuum deposition chamber analogous plate-shaped cathodes may be arranged as described above. Both first and second vacuum deposition chambers contain a carrier gas, such as for example argon, at a predetermined first pressure, preferably comprised between about 10⁻³ mbar and about 10⁻¹ mbar.

In particular, before being conveyed in the first vacuum deposition chamber, in order to preserve the first and, when used, the second vacuum deposition chamber from dust and other contaminants, a first pre-chamber and a second pre-chamber are arranged upstream of the first and, respectively, the second vacuum deposition chamber.

A third pre-chamber may be further provided downstream of the second vacuum deposition chamber. In other words, the first pre-chamber, the first vacuum deposition chamber, the second pre-chamber, the second vacuum deposition chamber and the third pre-chamber are successively arranged in series.

The first, the second and the third pre-chambers may contain argon subjected to a second predetermined pressure higher than said first predetermined pressure, for example in the order of 0.5 mbar.

In such way, the desired vacuum condition of 10⁻³ mbar - 10⁻¹ mbar is advantageously achieved in each vacuum deposition chamber in a stepwise manner.

The invention is further described by way of the following illustrative examples.

### EXAMPLE 1 (Invention)

A magnetron sputtering unit comprising a vacuum deposition chamber subjected to a first predetermined pressure of about 5·10⁻² mbar was used. A first pre-chamber and a second pre-chamber, both subjected to a second predetermined pressure higher than said first predetermined pressure (and equal to about 0.5 mbar) were arranged upstream and, respectively, downstream of the vacuum deposition chamber. The vacuum deposition chamber and the pre-chambers contained argon as carrier gas at the above-mentioned pressure values. Downstream of the second pre-chamber, drawing dies made of tungsten carbide were arranged in a bath containing a lubricating oil, namely an emulsion in water of 10% by weight of a lubricating agent.

The vacuum deposition chamber comprised 5 pairs of plate-shaped first and second rectangular cathodes (45 x 7 x 1 cm) made of brass (Cu 67%, Zn 33%), arranged on opposite sides of the wire bundle formed by the steel core conveyed along the above-mentioned multipassage path.

The distance d between each of the cathodes and the wire bundle was equal to about 3 cm.

A steel core having a diameter of about 1.14 mm was coated with a brass layer having an initial thickness of 1.5 µm. More particularly, the steel core was conveyed in a substantially continuous manner in the pre-chamber at a speed of about 70 m/min and successively in the vacuum deposition chamber along a multipassage path lying in a substantially horizontal plane. In order to obtain a radially outer and a radially inner portion of the coating layer, two respective portions (an initial portion and a final portion) of such path were arranged outside of a volume defined by a generatrix substantially perpendicular to a contour line of the assembly of cathodes arranged as described above. In this manner, the corresponding portions of the coating layer formed outside of such volume (i.e. the radially innermost portion and the radially outermost portion) had a second composition different from a first composition of the portion of the coating layer formed inside of such volume (i.e. a central portion, which had substantially the same compositions of the cathodes).

More particularly, in such portions of the path arranged outside of such volume, the angle of inclination of the brass beam with respect to the normal to the cathodes was of about 69°.

The path comprised a total number of 39 forward and backward lengths each measuring 250 cm and spaced apart by a distance p of about 6 mm. The two portions of path arranged outside of the above-mentioned volume protruded of about 8 cm with respect to the respective cathode edge.

The steel core was thus conveyed from an initial receiving position at which brass was sputtered along an incident direction inclined of 69° with respect to the normal to the cathodes to an intermediate receiving position at which brass was sputtered along an incident direction parallel to the normal to the cathodes and, finally, to a final receiving position at which brass was sputtered along an incident direction inclined of 69° with respect to the normal to the cathodes.

In this way, a radially outer portion having an initial thickness of 100 nm and a copper content of about 71.1 % by weight, a central portion having an initial thickness of 1.3 µm and a copper content of about 67.2%, i.e. substantially equal to the copper content of the brass alloy constituting the cathodes, as well as a radially inner portion having an initial thickness of 100 mn and a copper content of about 71.1% by weight were obtained.

The cathodes were sputtered onto the steel core in a substantially simultaneous manner until a total initial thickness of brass of about 1.5 µm was attained. The power source connected to the copper cathodes was of 9 kW. A voltage of about 360 V and a current of about 2.50 A were used. According to such working conditions (power, voltage, current, gas pressure values) a brass deposition rate of about 800 mn/min was achieved.

Subsequently, the steel core coated in the manner described above was conveyed in the second pre-chamber at a speed of about 70 m/min and finally drawn in the emulsion bath to a diameter of 0.20 mm, corresponding to a brass layer having a final thickness of 0.20 µm. As a result of such drawing step, the coating layer comprised a central portion having a thickness of 0.19 µm and an average copper content of 67.2%, a radially inner portion of coating layer having a thickness of 50 nm and a radially outer portion of coating layer having a thickness of 50 mm, both the radially inner portion and the radially outer portion having a copper content of 69.9%.

Finally, a stranding step of a plurality of steel wires coated with brass obtained as described above was provided so to form a cord.

### EXAMPLE 2 (Comparative)

The magnetron sputtering unit described in Example 1 was used. The vacuum deposition chamber comprised 5 pairs of plate-shaped first and second rectangular cathodes (45 x 7 x 1 cm) made of brass (Cu 67%, Zn 33%), arranged on opposite sides of a wire bundle at a distance d of 3 cm therefrom.

A steel core, having a diameter of about 1.14 mm, was coated with a brass coating layer having an initial thickness of 1.5 µm. The steel core was conveyed in the first pre-chamber as described in Example 1 and subsequently in the vacuum deposition chamber along a path comprising a total number of 13 forward and backward lengths each measuring 250 cm and spaced apart by a distance p of about 6 mm and under the same operative conditions described in Example 1 except for the power supplied to the cathodes, which was set to about 34 kW. Furthermore, differently from the Example 1, no portion of such path was arranged outside of a volume defined by a generatrix substantially perpendicular to a contour line of the assembly of cathodes arranged as described above.

In other words, the angle of inclination of the brass beam with respect to the normal to the cathodes was of about 0° along the entire path, so that the path did not protrude from any of the cathodes edges (thus resulting in a wire bundle having substantially the same width of the cathodes). As a consequence of such an arrangement of the path, the average copper content of the coating layer was of about 67.1% along the whole thickness of the coating layer.

Subsequently, the steel core coated with brass was conveyed in the second pre-chamber and finally drawn in the emulsion bath to a diameter of 0.20 mm, corresponding to a brass layer having a final thickness of 0.20 µm.

Finally, a stranding step of a plurality of steel wires coated with brass obtained as described above was provided to form a cord.

### EXAMPLE 3 (Invention)

The magnetron sputtering unit described in Example 1 was used. The vacuum deposition chamber comprised 5 pairs of plate-shaped first and second rectangular cathodes (45 x 7 x 1 cm) made of brass (Cu 67%, Zn 33%), arranged on opposite sides of a wire bundle at a distance of 3 cm therefrom.

A steel core, having a diameter of about 1.30 mm, was coated with a brass layer having an initial thickness of 1.5 µm. The steel core was conveyed in the first pre-chamber and subsequently in the vacuum deposition chamber as described in Example 1.

The steel core was conveyed in a substantially continuous manner in the pre-chamber at a speed of about 60 m/min, and successively in the vacuum deposition chamber along a multipassage path lying in a substantially horizontal plane and comprising a total number of 39 forward and backward lengths each measuring 250 cm and spaced apart of a distance p of about 5 mm. Two portions of such path, an initial portion and a final portion, were arranged outside of a volume defined by a generatrix substantially perpendicular to a contour line of the assembly of cathodes arranged as described above. In this manner, the corresponding portions of the coating layer formed outside of such volume (i.e. the radially innermost and the radially outermost portion) had a second composition different from a first composition of the portion of the coating layer formed inside of such volume (i.e. the central portion).

The portions of the path arranged outside of the above-mentioned volume protruded of about 6 cm from the edges of the respective cathode, thus resulting, in correspondence of said path portions, in an incident angle of inclination of the brass beam emitted by the cathodes with respect to the normal to the cathodes of about 63°.

The other operative conditions were the same as those described in Example 1.

In this way, a radially outer and a radial inner portion of the coating layer both having an initial thickness of 100 nm and a copper content of about 69.1 % by weight, as well as a central portion having an initial thickness of 1.3 µm and a copper content of about 67% were obtained.

Subsequently, the steel core coated with brass was conveyed in the second pre-chamber and finally drawn in the emulsion bath to a diameter of 0.22 mm, corresponding to a brass layer having a final thickness of 0.20 µm.

As a result of such drawing step, the coating layer comprised a central portion having a final thickness of 0.19 µm including an average copper content of 67.1%, and radially inner and outer portions of the coating layer both having a final thickness of 50 nm and an average copper content of 69% were obtained.

Finally, a stranding step of a plurality of steel wires coated with brass obtained as described above was provided to form a cord.

The different cords obtained starting from the coated steel wires produced according to Examples 1-3 had different reactivities. More particularly, the cords of Example 1 had a reactivity greater than the reactivity of the cords of Example 3 which, in turn, had a reactivity greater than the reactivity of the cords of Example 2.

## Claims

1. A method for producing a coated metal wire comprising a steel core (6) and a coating layer made of a metal alloy material including at least one first metal component and at least one second metal component, said first and second metal component of the coating layer being selected from the group consisting of copper, zinc, manganese, cobalt, tin, molybdenum, iron, nickel, aluminum the method comprising the steps of:
a. conveying said steel core along a predetermined path in a substantially continuous manner, said predetermined path being positioned in proximity of at least one cathode (1, 2) made of said metal alloy material having a first composition; and
b. sputtering said at least one cathode (1, 2) onto said steel core (6) being conveyed along said predetermined path to obtain said coating layer;
wherein at least one portion of said predetermined path lies outside of a volume defined by a generatrix substantially perpendicular to a contour line of said at least one cathode (1, 2), so that the coating layer formed when said steel core is conveyed in correspondence of said at least one portion of said predetermined path has a second composition different from the first composition and wherein said sputtering step is carried out by means of a magnetron sputtering technique involving a ionic bombardment of said at least one cathode (1,2);
wherein said at least one portion of path lying outside of said volume protrudes from at least one edge of said at least one cathode (1,2) of a predetermined length (I), and the ratio between said length (I) of the portion of path protruding from at least one edge of said at least one cathode (1,2) and the distance (d) between said at least one cathode (1,2) and the steel core (6) is comprised between 1.5 and 3.2.

2. The method according to claim 1, wherein said path lies on a plane arranged substantially parallel to said at least one cathode (1, 2).

3. The method according to claim 1, wherein said steel core (6) is conveyed from an initial receiving position lying inside said volume to a final receiving position lying outside said volume.

4. The method according to claim 1, wherein said steel core (6) is conveyed from an initial receiving position lying outside said volume to a final receiving position lying inside said volume.

5. The method according to claim 1, wherein said steel core (6) is conveyed from an initial receiving position lying outside said volume to a final receiving position lying outside said volume.

6. The method according to claim 1, wherein said conveying step is carried out along a path comprising a plurality of successive forward and backward lengths parallel to each other to form a bundle (5) of wire lengths.

7. The method according to claim 6, wherein adjacent forward and backward lengths are spaced apart by a predetermined distance (p).

8. The method according to any one of the preceding claims, wherein said sputtering step is carried out until a predetermined initial thickness of said coating layer is attained.

9. The method according to claim 1, wherein the coating layer formed when said steel core is conveyed in correspondence of said at least one portion of said predetermined path is a radially outer portion of the coating layer.

10. The method according to claim 1, wherein the coating layer formed when said steel core is conveyed in correspondence of said at least one portion of said predetermined path is a radially inner portion of the coating layer.

11. The method according to claim 8, wherein the coating layer formed when said steel core is conveyed in correspondence of said at least one portion of said predetermined path has an initial thickness of about 3-10% of the initial thickness of the whole coating layer.

12. The method according to claim 8, further comprising the step of drawing the coated steel wire until the steel core (6) has a final diameter smaller than a predetermined initial diameter and the coating layer has a final thickness smaller than said predetermined initial thickness.

13. A coated metal wire comprising a steel core (6) and a coating layer made of a metal alloy material including at least one first metal component and at least one second metal component, said metal alloy is brass, said coating layer comprising a radially inner portion, a radially outer portion and a central portion arranged between said radially inner portion and said radially outer portion, wherein the radially inner portion has a first composition, the radially outer portion has a third composition and the central portion has a second composition different from both the first composition and the third composition wherein said radially outer portion has a final thickness comprised between about 25 nm and about 75 nm
**characterised in that**
said radially inner portion has a copper content from 1 % to 8% by weight higher than the copper content of said central portion.

14. The coated metal wire according to claim 13, wherein said first composition is equal to said third composition.

15. The coated metal wire according to claim 13, wherein the radially outer portion has a copper content from 1 % to 8% by weight higher than the copper content of the central portion.

16. The coated metal wire according to claim 13, wherein the central portion has a copper content of 60 to 72%.

17. A method for producing a metal cord comprising the steps of producing a plurality of coated metal wires produced by a method according to any one of claims 1-12 and the further step of stranding together said plurality of coated metal wires.

18. A metal cord for reinforcing an elastomeric material, comprising a plurality of coated metal wires according to any one of claims 13-16, said coated metal wires being stranded together.

## Patentansprüche

1. Verfahren zum Herstellen eines überzogenen Metalldrahts, der einen Stahlkern (6) und eine Überzugsschicht, die aus einem Metalllegierungsmaterial hergestellt ist, das mindestens eine erste Metallkomponente und mindestens eine zweite Metallkomponente enthält, umfasst, wobei die erste und die zweite Metallkomponente der Überzugsschicht aus der Gruppe ausgewählt sind, die aus Kupfer, Zink, Mangan, Cobalt, Zinn, Molybdän, Eisen, Nickel und Aluminium besteht, wobei das Verfahren die folgenden Schritte umfasst:
a. Befördern des Stahlkerns entlang eines vorgegebenen Pfads in einer im Wesentlichen kontinuierlichen Art, wobei der vorgegebene Pfad in der Nähe von mindestens einer Kathode (1, 2), die aus dem Metalllegierungsmaterial mit einer ersten Zusammensetzung hergestellt ist, positioniert ist; und
b. Sputtern der mindestens einen Kathode (1, 2) auf den Stahlkern (6), der entlang des vorgegebenen Pfads befördert wird, um die Überzugsschicht zu erhalten;
wobei mindestens ein Abschnitt des vorgegebenen Pfads außerhalb eines Volumens, das durch eine Erzeugende, die im Wesentlichen senkrecht zu einer Konturlinie der mindestens einen Kathode (1, 2) liegt, definiert ist, derart liegt, dass die Überzugsschicht, die dann gebildet wird, wenn der Stahlkern entsprechend dem mindestens einen Abschnitt des vorgegebenen Pfads befördert wird, eine zweite Zusammensetzung, die eine andere als die erste Zusammensetzung ist, aufweist, und wobei der Schritt des Sputterns mittels einer Technik des Magnetronsputterns, die ein Ionenbombardement der mindestens einen Kathode (1, 2) einbezieht, ausgeführt wird;
wobei der mindestens eine Abschnitt des Pfads, der außerhalb des Volumens liegt, von mindestens einer Kante der mindestens einen Kathode (1, 2) um eine vorgegebene Länge (I) hervorsteht, und wobei das Verhältnis zwischen der Länge (I) des Abschnitts des Pfads, der von mindestens einer Kante der mindestens einen Kathode (1, 2) hervorsteht, und des Abstands (d) zwischen der mindestens einen Kathode (1, 2) und dem Stahlkern (6) zwischen 1,5 und 3,2 liegt.

2. Verfahren nach Anspruch 1, wobei der Pfad in einer Ebene liegt, die im Wesentlichen parallel zu der mindestens einen Kathode (1, 2) angeordnet ist.

3. Verfahren nach Anspruch 1, wobei der Stahlkern (6) von einer anfänglichen Aufnahmeposition, die innerhalb des Volumens liegt, zu einer abschließenden Aufnahmeposition, die außerhalb des Volumens liegt, befördert wird.

4. Verfahren nach Anspruch 1, wobei der Stahlkern (6) von einer anfänglichen Aufnahmeposition, die außerhalb des Volumens liegt, zu einer abschließenden Aufnahmeposition, die innerhalb des Volumens liegt, befördert wird.

5. Verfahren nach Anspruch 1, wobei der Stahlkern (6) von einer anfänglichen Aufnahmeposition, die außerhalb des Volumens liegt, zu einer abschließenden Aufnahmeposition, die außerhalb des Volumens liegt, befördert wird.

6. Verfahren nach Anspruch 1, wobei der Beförderungsschritt entlang eines Pfads ausgeführt wird, der mehrere aufeinanderfolgende nach vorwärts und rückwärts gerichtete Längen umfasst, die zueinander parallel sind, um ein Bündel (5) von Drahtlängen zu bilden.

7. Verfahren nach Anspruch 6, wobei benachbarte vorwärts und rückwärts gerichtete Längen durch einen vorgegebenen Abstand (p) beabstandet sind.

8. Verfahren nach einem der vorhergehenden Ansprüche, wobei der Schritt des Sputterns so lange ausgeführt wird, bis eine vorgegebene, anfängliche Dicke der Überzugsschicht erreicht ist.

9. Verfahren nach Anspruch 1, wobei die Überzugsschicht, die gebildet wird, wenn der Stahlkern entsprechend dem mindestens einen Abschnitt des vorgegebenen Pfads befördert wird, ein radial äußerer Abschnitt der Überzugsschicht ist.

10. Verfahren nach Anspruch 1, wobei die Überzugsschicht, die gebildet wird, wenn der Stahlkern entsprechend dem mindestens einen Abschnitt des vorgegebenen Pfads befördert wird, ein radial innerer Abschnitt der Überzugsschicht ist.

11. Verfahren nach Anspruch 8, wobei die Überzugsschicht, die gebildet wird, wenn der Stahlkern entsprechend dem mindestens einen Abschnitt des vorgegebenen Pfads befördert wird, eine anfängliche Dicke von etwa 3-10 % der anfänglichen Dicke der gesamten Überzugsschicht aufweist.

12. Verfahren nach Anspruch 8, das ferner den Schritt des Ziehens des überzogenen Stahldrahts so lange, bis der Stahlkern (6) einen Enddurchmesser aufweist, der kleiner als ein vorgegebener, anfänglicher Durchmesser ist, und bis die Überzugsschicht eine Enddicke aufweist, die kleiner als die vorgegebene anfängliche Dicke ist, umfasst.

13. Überzogener Metalldraht, der einen Stahlkern (6) und eine Überzugsschicht, die aus einem Metalllegierungsmaterial hergestellt ist, das mindestens eine erste Metallkomponente und mindestens eine zweite Metallkomponente enthält, umfasst, wobei die Metalllegierung Messing ist, wobei die Überzugsschicht einen radial inneren Abschnitt, einen radial äußeren Abschnitt und einen zentralen Abschnitt, der zwischen dem radial inneren Abschnitt und dem radial äußeren Abschnitt angeordnet ist, umfasst, wobei der radial innere Abschnitt eine erste Zusammensetzung, der radial äußere Abschnitt eine dritte Zusammensetzung und der zentrale Abschnitt eine zweite Zusammensetzung, die eine andere als die erste Zusammensetzung und die dritte Zusammensetzung ist, aufweist, wobei der radial äußere Abschnitt eine Enddicke aufweist, die zwischen etwa 25 nm und etwa 75 nm liegt,
**dadurch gekennzeichnet, dass**
der radial innere Abschnitt einen Kupfergehalt von 1 Gew.% bis 8 Gew.% aufweist, der höher als der Kupfergehalt des zentralen Abschnitts ist.

14. Überzogener Metalldraht nach Anspruch 13, wobei die erste Zusammensetzung gleich der dritten Zusammensetzung ist.

15. Überzogener Metalldraht nach Anspruch 13, wobei der radial äußere Abschnitt einen Kupfergehalt von 1 Gew.% bis 8 Gew.% aufweist, der höher als der Kupfergehalt des zentralen Abschnitts ist.

16. Überzogener Metalldraht nach Anspruch 13, wobei der zentrale Abschnitt einen Kupfergehalt von 60 bis 72 % aufweist.

17. Verfahren zum Herstellen eines Metallkords, das die Schritte des Herstellens mehrerer überzogener Metalldrähte, die von einem Verfahren nach einem der Ansprüche 1 bis 12 hergestellt werden, und den weiteren Schritt, die mehreren überzogenen Metalldrähte zusammen zu verseilen, umfasst.

18. Metallkord zum Verstärken eines elastomeren Materials, das mehrere überzogene Metalldrähte nach einem der Ansprüche 13 bis 16 umfasst, wobei die überzogenen Metalldrähte zusammen verseilt sind.

## Revendications

1. Procédé pour la production d'un fil métallique enrobé comprenant une âme en acier (6) et une couche d'enrobage constituée d'un matériau en alliage métallique comprenant au moins un premier composant métallique et au moins un second composant métallique, lesdits premier et second composants métalliques de la couche d'enrobage étant choisis dans le groupe constitué par le cuivre, le zinc, le manganèse, le cobalt, l'étain, le molybdène, le fer, le nickel et l'aluminium, le procédé comprenant les étapes de :
a. transport de ladite âme en acier le long d'un cheminement prédéfini d'une manière pratiquement continue, ledit cheminement prédéfini étant positionné à proximité d'au moins une cathode (1, 2) constituée dudit matériau en alliage métallique ayant une première composition ; et
b. pulvérisation cathodique de ladite au moins une cathode (1, 2) sur ladite âme en acier (6) en train d'être transportée le long dudit cheminement prédéfini pour obtenir ladite couche d'enrobage ;
dans lequel au moins une partie dudit cheminement prédéfini se situe à l'extérieur d'un volume délimité par une génératrice pratiquement perpendiculaire à une ligne de contour de ladite au moins une cathode (1, 2), de sorte que la couche d'enrobage formée lorsque ladite âme en acier est transportée en correspondance avec ladite au moins une partie dudit cheminement prédéfini a une seconde composition différente de la première composition et dans lequel ladite étape de pulvérisation cathodique est effectuée au moyen d'une technique de pulvérisation cathodique magnétron mettant en jeu un bombardement ionique de ladite au moins une cathode (1, 2) ;
dans lequel ladite au moins une partie de cheminement se situant à l'extérieur dudit volume dépasse d'au moins un bord de ladite au moins une cathode (1, 2) d'une longueur prédéfinie (1) et le rapport entre ladite longueur (1) de la partie de cheminement dépassant d'au moins un bord de ladite au moins une cathode (1, 2) et la distance (d) entre ladite au moins une cathode (1, 2) et l'âme en acier (6) est compris entre 1,5 et 3,2.

2. Procédé selon la revendication 1, dans lequel ledit cheminement se situe sur un plan disposé pratiquement parallèlement à ladite au moins une cathode (1, 2).

3. Procédé selon la revendication 1, dans lequel ladite âme en acier (6) est transportée d'un endroit de réception initial se situant à l'intérieur dudit volume à un endroit de réception final se situant à l'extérieur dudit volume.

4. Procédé selon la revendication 1, dans lequel ladite âme en acier (6) est transportée d'un endroit de réception initial se situant à l'extérieur dudit volume à un endroit de réception final se situant à l'intérieur dudit volume.

5. Procédé selon la revendication 1, dans lequel ladite âme en acier (6) est transportée d'un endroit de réception initial se situant à l'extérieur dudit volume à un endroit de réception final se situant à l'extérieur dudit volume.

6. Procédé selon la revendication 1, dans lequel ladite étape de transport est effectuée le long d'un cheminement comprenant une pluralité de longueurs d'aller et de retour successives parallèles les unes aux autres pour former une botte (5) de longueurs de fil.

7. Procédé selon la revendication 6, dans lequel les longueurs d'aller et de retour adjacentes sont espacées les unes des autres d'une distance prédéfinie (p).

8. Procédé selon l'une quelconque des revendications précédentes, dans lequel ladite étape de pulvérisation cathodique est effectuée jusqu'à ce qu'une épaisseur initiale prédéfinie de ladite couche d'enrobage soit atteinte.

9. Procédé selon la revendication 1, dans lequel la couche d'enrobage formée lorsque ladite âme en acier est transportée en correspondance avec ladite au moins une partie dudit cheminement prédéfini est une partie radialement externe de la couche d'enrobage.

10. Procédé selon la revendication 1, dans lequel la couche d'enrobage formée lorsque ladite âme en acier est transportée en correspondance avec ladite au moins une partie dudit cheminement prédéfini est une partie radialement interne de la couche d'enrobage.

11. Procédé selon la revendication 8, dans lequel la couche d'enrobage formée lorsque ladite âme en acier est transportée en correspondance avec ladite au moins une partie dudit cheminement prédéfini a une épaisseur initiale d'environ 3-10 % de l'épaisseur initiale de la couche d'enrobage entière.

12. Procédé selon la revendication 8, comprenant en outre l'étape d'étirage du fil d'acier enrobé jusqu'à ce que l'âme en acier (6) ait un diamètre final plus petit qu'un diamètre initial prédéfini et la couche d'enrobage ait une épaisseur finale plus petite que ladite épaisseur initiale prédéfinie.

13. Fil métallique enrobé comprenant une âme en acier (6) et une couche d'enrobage constituée d'un matériau en alliage métallique comprenant au moins un premier composant métallique et au moins un second composant métallique, ledit alliage métallique étant du laiton, ladite couche d'enrobage comprenant une partie radialement interne, une partie radialement externe et une partie centrale disposée entre ladite partie radialement interne et ladite partie radialement externe, dans lequel la partie radialement interne a une première composition, la partie radialement externe a une troisième composition et la partie centrale a une deuxième composition différente à la fois de la première composition et de la troisième composition, dans lequel ladite partie radialement externe a une épaisseur finale comprise entre environ 25 nm et environ 75 nm,
**caractérisé en ce que**
ladite partie radialement interne a une teneur en cuivre de 1 % à 8 % en poids plus élevée que la teneur en cuivre de ladite partie centrale.

14. Fil métallique enrobé selon la revendication 13, dans lequel ladite première composition est égale à ladite troisième composition.

15. Fil métallique enrobé selon la revendication 13, dans lequel la partie radialement externe a une teneur en cuivre de 1 % à 8 % en poids plus élevée que la teneur en cuivre de la partie centrale.

16. Fil métallique enrobé selon la revendication 13, dans lequel la partie centrale a une teneur en cuivre de 60 à 72 %.

17. Procédé pour la production d'un câblé métallique comprenant les étapes de production d'une pluralité de fils métalliques enrobés produits par un procédé selon l'une quelconque des revendications 1-12 et l'étape supplémentaire de toronnage de ladite pluralité de fils métalliques enrobés les uns avec les autres.

18. Câblé métallique pour le renforcement d'un matériau élastomère, comprenant une pluralité de fils métalliques enrobés selon l'une quelconque des revendications 13-16, lesdits fils métalliques enrobés étant toronnés les uns avec les autres.
